# EUROPÄISCHE PATENTANMELDUNG

(11) **EP 1 806 641 A2**
(43) Veröffentlichungstag der Anmeldung: **11.07.2007**
(21) Anmeldenummer: 06023928.2
(22) Anmeldetag: 17.11.2006
(51) Int. Cl.: G06F 1/16, G06F 1/18, H05K 7/14

(54) **Display-Auszug**

(30) Priorität: 10.01.2006 DE 202006000313 U
(71) Anmelder: Knürr AG, 94424 Arnstorf (DE)
(72) Erfinder: Gramelsberger, Stefan, 94428 Eichendorf - Aufhausen (DE); Priller, Siegbert, 84098 Weihenstephan (DE); Rickinger, Thomas, 94424 Arnstorf (DE); Schiessleder, Christian, 94419 Reisbach-Haberskirchen (DE)
(74) Vertreter: Heim, Hans-Karl

(57) **Zusammenfassung**

Die Erfindung betrifft einen Display-Auszug für Elektronikschränke oder Elektronikgeräte, mit mindestens einem Display und mit mindestens einem Eingabe-Interface. Das mindestens eine Display und das mindestens eine Eingabe-Interface sind von einer Platz sparenden Aufbewahrungsposition in einem Elektronikschrank oder Elektronikgerät, in eine Arbeitsposition überführbar. Des Weiteren ist mindestens ein Eingabe-Interface als Tastatur ausgeführt. Außerdem sind an der rückwärtigen Seite des Display-Auszuges Steck-Anschlüsse für eine trennbare Energieversorgung vorgesehen.

## Beschreibung

Die Erfindung betrifft einen Display-Auszug, insbesondere eine TFT-Schublade, für Elektronikschränke oder Elektronikgeräte gemäß Oberbegriff des Anspruchs 1.

Derartige Display-Auszüge weisen mindestens ein im Wesentlichen flaches Display und mindestens ein Eingabe-Interface auf. Hierbei sind das Display und das Eingabe-Interface von einer Platz sparenden Aufbewahrungsposition in eine Arbeitsposition überführbar. Als Eingabe-Interface können beispielsweise Tastatur, Maus oder andere taktile Eingabe-Interfaces vorgesehen sein.

Elektronikschränke, welche oft 19"-Format aufweisen, sind bekannt. Sie werden zum Beispiel in Rechnerräumen eingesetzt, um Server und Netzwerkkomponenten Platz sparend und übersichtlich unterzubringen. Im normalen Betrieb benötigen diese Server keine Ein- und Ausgabeeinrichtungen wie Monitore oder Tastaturen. Sie werden meist über ein Netzwerk angesprochen, über das auch ihre EDV-Kapazität ansteuerbar und abrufbar ist.

Beim Aufbau sowie der Konfiguration derartiger Server ist es oft vorteilhaft, lokal vorhandene Ein- und Ausgabeeinrichtungen einzusetzen, um die notwendigen Einstellungen und Überprüfungen einfacher und schneller ausführen zu können.

Hierzu bietet sich zum einen an, neben dem Elektronikschrank zusätzlich Monitor und Eingabeeinrichtungen wie Tastatur und/oder Maus vorzusehen. Eine Anordnung neben den Schränken ist aber nachteilig, da zum einen zusätzliche Kabel von den Schränken nach außen zu führen sind. Zum anderen wird durch diese externe Anordnung zusätzlich Platz beansprucht.

Eine andere Möglichkeit besteht darin, den Monitor und die Eingabeeinrichtungen ebenfalls in den Elektronikschrank, zum Beispiel den 19"-Schrank zu integrieren. Hierbei gibt es bei herkömmlichen Röhrenmonitoren den Nachteil, dass sie sehr viel Platz beanspruchen und so die Aufnahmekapazität des Schrankes vermindert wird. Durch die Einführung von flachen Bildschirmen wurden neue Anordnungsmöglichkeiten möglich.

Beispielsweise ist in US 5,388,032 eine Vorrichtung beschrieben, in der ein flacher Bildschirm, der aufklappbar angeordnet ist, zusätzlich auf einem Tastaturauszug angeordnet ist. Die Tastatur, die hierbei eingesetzt wird, entspricht einer herkömmlichen Tastatur, die ebenfalls auf dem Auszug platziert ist. Nachteilig an dieser Konstruktion ist, dass die Anschlusskabel des Bildschirms, beziehungsweise der Tastatur direkt mit dem Server oder einer KVM-Switch verbunden sind. Diese Anschlusskabel sind jeweils mindestens 2 bis 3 m lang. Bei einem Austausch der Tastatur muss das Kabel direkt am Server oder am KVM-Switch abgesteckt und ein neues dort angesteckt werden. Dieses ist bei integriert gebauten 19"-Schränken nur schwer möglich und erfordert oft einen Abbau der rückseitigen Wände oder anderer Bauteile, wie Server und Switches. Somit ist ein Austausch dieser Komponenten sehr zeit- und damit kostenaufwändig. Auch können in der beschriebenen Vorrichtung nur relativ kleine Bildschirme vorgesehen werden.

Der Erfindung liegt die Aufgabe zugrunde, einen Display-Auszug für Elektronikschränke oder Elektronikgeräte zu schaffen, der effektiv und einfach austauschbar ist und einen hohen Integrationsgrad aufweist.

Die Aufgabe wird erfindungsgemäß durch einen Display-Auszug mit den Merkmalen des Anspruchs 1 gelöst.

Demnach ist vorgesehen, dass an der rückwärtigen Seite des Display-Auszuges Steckanschlüsse, insbesondere für eine trennbare Display-, Interface- und/oder Energieversorgung, vorgesehen sind. Weiterhin ist mindestens die Tastatur durch einzelne Tastaturmodule, die auf einer Leiterplatte integriert sind, ausgebildet.

Weitere vorteilhafte Ausführungsformen sind in den abhängigen Ansprüchen, der Beschreibung, den Figuren und der Figurenbeschreibung angegeben.

Ein Grundgedanke der Erfindung ist es, die herkömmlich verwendeten langen Kabel, die von den Eingabe-Interfaces, wie einer Tastatur oder einer mausartigen Eingabemöglichkeit, dem Bildschirm oder zur Energieversorgung dienten, nicht mehr direkt bis zu einem Server oder einer entsprechenden Ansteuerungs- bzw. Versorgungseinrichtung zu führen. An Stelle dessen werden Anschlusseinrichtungen, beispielsweise Steckanschlüsse für alle notwendigen Verbindungen des Display-Auszuges, an der Rückseite dieses Auszuges vorgesehen. An diese Anschlüsse werden dann Verbindungskabel zu den entsprechenden Versorgungs- oder Schalteinrichtungen, wie beispielsweise der Stromversorgung, einem Server oder einem KVM-Switch angeschlossen. Durch die zusätzlichen trennbaren Schnittstellen der Leitungen ist es nun besonders einfach möglich, einen derartigen Display-Auszug durch einfaches Herausnehmen auszutauschen, ohne große Um- und Ausbauten an Servern, Geräteschränken oder Elektronikgeräten vorzunehmen.

Als Display können grundsätzlich alle beliebigen flachen Display-Arten eingesetzt werden. Hierbei bieten sich bevorzugt TFT- oder LCD-Displays an. Es ist aber auch möglich, andere Anzeigesysteme, wie beispielsweise Plasmabildschirme, zu verwenden. Die Wahl des Anzeigemoduls hängt auch von dem Anwendungszweck der Vorrichtung, in die der Display-Auszug eingebaut ist, ab. Bei Elektronikschränken, beispielsweise zur Netzwerksteuerung oder Serverschränken zum Betrieb von Rechnern, bietet sich ein TFT-Display an. Wird der Display-Auszug aber in Elektronikgeräten verwendet, die andere Anzeigen benötigen, oder keine entsprechenden Schnittstellen aufweisen, so können auch andere Anzeigen, beispielsweise basierend auf LEDs, vorgesehen werden.

Ein weiterer Grundgedanke der Erfindung liegt darin, nicht eine herkömmliche Tastatur einzusetzen, sondern auf dem Display-Auszug eine integrierte Tastatur, die aus einzelnen Tastaturmodulen besteht, aufzubauen. Diese Tastaturmodule können dann auf einer Hauptleiterplatte einzeln vorgesehen sein. Durch einen derartigen Aufbau sind keine weiteren zusätzlichen Ankopplungsgeräte von der Tastatur zu den rückwärtigen Anschlüsse des Display-Auszuges notwendig. Außerdem kann durch einen derartigen Aufbau der Platzbedarf einer Tastatur minimiert werden und diese ebenso äußerst einfach auf spezielle Anwendungszwecke angepasst werden.

Grundsätzlich kann die Tastatur auf herkömmliche Art beschriftet sein, beispielsweise durch Aufdrucken oder Aufkleben von entsprechenden Symbolen. Besonders prägnant und druckbildscharf lässt sie sich aber beschriften, wenn die einzelnen Tastenmodule so ausgelegt sind, dass sie durch Laser beschriftet werden können. Diese Art der Beschriftung ist besonders abriebfest und einfach auszuführen.

Als weitere Eingabeeinrichtung können beispielsweise Mäuse, Touchpads, Trackbälle oder (Mini-) Joysticks vorgesehen sein. Es ist besonders vorteilhaft, wenn eine integrierte Aufnahme für ein Touchpad auf der Leiterplatte vorgesehen ist. Durch die weite Verbreitung von Touchpads für Laptops sind diese im Vergleich zu anderen Eingabeeinrichtungen relativ günstig zu produzieren und außerdem haben sie bei der Bedienung keinen großen Platzbedarf. Wird ein Touchpad integriert in der Leiterplatte vorgesehen, so entfallen aufwändige Verbindungsarbeiten und der vorteilhafte Aufbau des Display-Auszuges mit einer zentralen Leiterplatte kann auch hierbei weiterhin verfolgt werden. Um bei einer längeren Arbeitszeit an dem Display-Auszug das Arbeiten ergonomisch gestalten zu können, ist es vorteilhaft, wenn beabstandet zum Touchpad beidseitig abgerundete Handballenauflagen, beispielsweise aus Moosgummi, vorgesehen sind. Die Handballenauflagen sind zweckmäßig und designerisch zur Bedienungsseite hin, abgerundet ausgebildet.

Zur einfacheren Ansteuerung beispielsweise der Tastaturmodule auf der Leiterplatte ist es bevorzugt, wenn Interface-Controller auf dieser vorgesehen sind. Beispiele hierfür sind, zur Ansteuerung von Tastatur oder Maus, PS/2 oder USB-Controller. Grundsätzlich sind aber auch andere Interfaces mit entsprechenden Controllern auf der Leiterplatte integrierbar, z.B. ein USB-Hub oder ein serieller Anschluss. Weiterhin ist die Leiterplatte bevorzugt als Mehrschicht-Leiterplatte ausgebildet.

Da mittlerweile Elektronischränke oder Elektronikgeräte nicht mehr rein als funktionale Elemente angesehen werden, sondern auch designmäßig beurteilt werden, ist es besonders vorteilhaft, wenn an der Vorderseite des Auszuges eine austauschbare Blende vorgesehen ist. Diese Blende kann den Benutzerwünschen entsprechend angepasst werden. In der Aufbewahrungsposition ist nur die Blende als Front zu sehen. Um den Display-Auszug besonders einfach von der Aufbewahrungsposition in die Arbeitsposition zu überführen, ist es besonders vorteilhaft, wenn vertikale Trage- und Gleitschienen vorgesehen sind. Diese Schienen können konstruktiv am Elektronikschrank oder dem Elektronikgerät befestigt sein. Durch ein derartiges Anbringen wird kein zusätzlicher Platz in dem Elektronikschrank benötigt und es ist für einen Nutzer sehr einfach, den Auszug in die Arbeitsposition zu überführen.

Um eine hohe Integrierbarkeit in Elektronikschränken, beispielsweise 19"-Schränken, zu unterstützen, können die Außenabmessungen des Display-Auszuges für derartige Schränke ausgelegt sein. Ebenso ist es vorteilhaft, wenn der Auszug nur wenige HEs, insbesondere 1 HE, an Höhe in derartigen Schränken beansprucht. Diese flache Bauweise wird dadurch unterstützt, dass das Display von einer Aufbewahrungsposition in eine Arbeitsposition geklappt werden kann, in der es im Wesentlichen senkrecht zu der Tastatur steht. In der Aufbewahrungsposition kann das Display beispielsweise flach auf eine Eingabe-Interface, wie einer Tastatur, abgeklappt und aufgelegt werden. Durch eine derartige Anordnung können auch große Displays verwendet werden, da sie Platz sparend untergebracht werden können. Die Maximalausmaße des Display-Auszuges sind im Wesentlichen nur durch die Tiefe und Breite des Schrankes begrenzt. Es ist durch die Lagerung des Displays über den Eingabe-Interfaces möglich, mit dem Display beinahe den kompletten Raum des Auszuges einzunehmen, und so relativ große Displays zu verwenden. Hierdurch ist die Verwendung von 15" oder 17" Displays bei einem derartigen Display-Auszug in den weit verbreiteten 19" Serverschränken möglich.

In einer bevorzugten Ausführungsform ist es ebenso denkbar, zusätzlich in dem Display-Auszug KVM-Switches unterzubringen, um besonders einfach mehrere Server ansteuern zu können. Hierbei weisen die Switches wiederum nur Anschlüsse auf, an die dann die Verbindungskabel zu den einzelnen Servern angeschlossen werden können.

Die Erfindung wird nachfolgend anhand eines Ausführungsbeispiels und schematischer Zeichnungen näher erläutert. In diesen Zeichnungen zeigen:
- Fig. 1: eine Ansicht von schräg vorne auf einen Display-Auszug mit aufgeklapptem Display;
- Fig. 2: eine Ansicht von schräg vorne auf einen Display-Auszug mit abgeklapptem Display; und
- Fig. 3: eine Ansicht von schräg hinten auf einen Display-Auszug mit abgeklapptem Display.

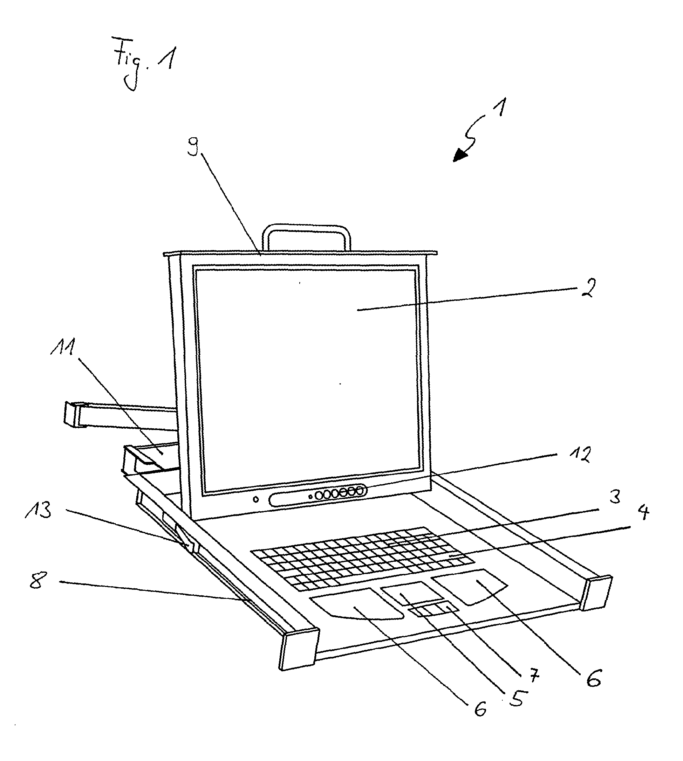

In Fig. 1 ist ein Display-Auszug 1 mit aufgeklapptem Display 2, das hier als TFT-Display ausgeführt ist, in Form einer TFT-Schublade gezeigt. Der Display-Auszug 1 ist zur besseren Übersicht außerhalb eines Elektronikschrankes oder Elektronikgerätes dargestellt.

In der Umfassung des Displays 2 ist ein Bedienfeld 12 für Display-Funktionen wie beispielsweise Helligkeit oder Kontrast vorgesehen. Ein Aktivieren, das heißt das An-Schalten des Displays 2 erfolgt bevorzugt durch Aufklappen des Displays 2 von der Platz sparenden Aufbewahrungsposition in die hier dargestellte Arbeitsposition. Hierbei können am Klappmechanismus oder am Auszugsmechanismus des Display-Auszuges 1 entsprechende Schalter beziehungsweise Kontaktstellen vorgesehen sein.

Auf der ebenen Fläche vor dem Display 2 befindet sich eine Tastatur 3, ein Touchpad 5 mit zugeordneter Mausersatztasten 7 und Handballenauflagen 6. Die Tastatur 3 ist nicht als eine herkömmliche Tastatur ausgebildet, sondern besteht aus einzelnen Tastaturmodulen 4. Die einzelnen Tastaturmodule 4 sind auf der hier durch eine Abdeckung abgeschlossenen Leiterplatte integriert angebracht. Sie sind laserbeschriftet ausgeführt. Die extrem flache und somit Platz sparende Fläche mit den Interfaces wird durch die Integration der einzelnen Interfaces auf die zur Verbindung und als Träger dienende mehrschichtige Leiterplatte ermöglicht.

Durch die Verwendung einzelner Tastaturmodule 4 ist die Tastaturverteilung je nach Einsatzzweck besonders einfach in der Produktion variierbar. So können integrierte laptopähnliche Tastaturen aufgebaut werden, aber auch Tastaturen mit separatem Nummernblock, oder weiteren Zusatztasten, wie sie von manchen Sun-Systemen benötigt werden. Die Form der Handballenauflagen 6 und der Mausersatztasten 7 ist in optisch ansprechender Weise in Art eines Kreissegmentes gestaltet. Seitlich an dem Display-Auszug 1 sind die Auszugschienen 8 zu erkennen. Das dazugehörige Bauelement, die Trage- und Befestigungsschienen 21, die in dem Elektronikschrank oder -gerät angebracht sind, sind hier nicht dargestellt. An den Auszugschienen 8 befindet sich ein Federelement 13, das zum Einrasten des Display-Auszuges dient, wenn er ausgezogen ist. An der Rückseite, welche in dieser Darstellung durch das Display 2 teilweise verdeckt ist, ist eine Kabelführung 11 abgebildet. Diese dient zur geordneten Zuführung der Anschlusskabel für die Steckanschlüsse 31.

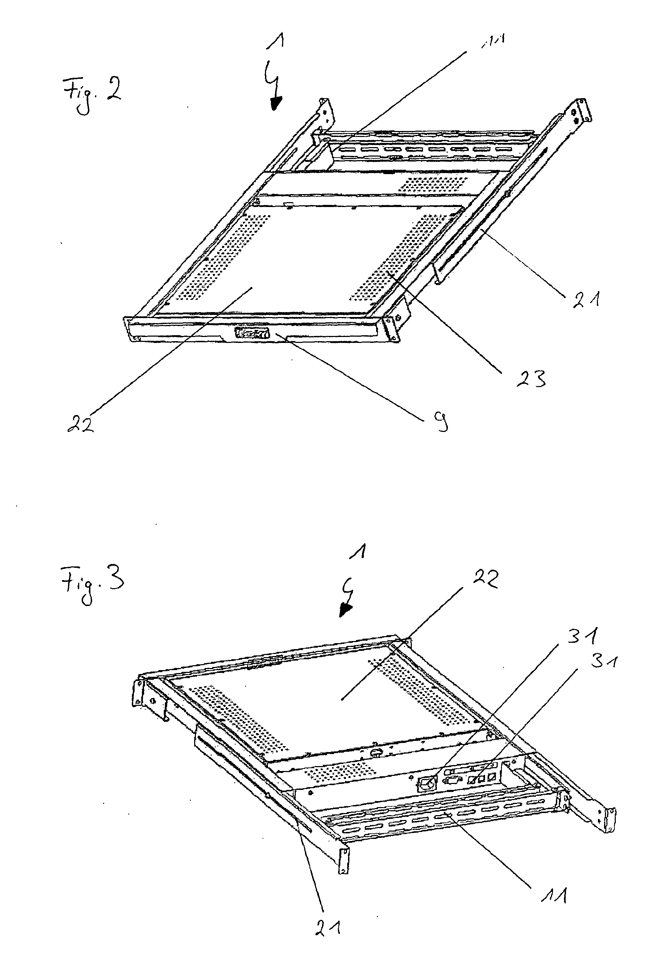

In den Fig. 2 und 3 ist ein Display-Auszug 1 in geschlossenem Zustand dargestellt. Diese Position entspricht der Aufbewahrungsposition. Der in Fig. 2 und 3 dargestellte Display-Auszug 1 weist eine andere Blende 9 auf, als der Auszug 1 aus Fig. 1. In den Abbildungen 2 und 3 sind die Befestigungs- und Tragschienen 21 dargestellt. Im eingeklappten Zustand des Displays 2 sind Luftlöcher 23, die zur Kühlung und zur Abfuhr von WarmLuft des Displays beziehungsweise dessen Transformatoren oder anderer Bauelemente dienen, sichtbar.

In Fig. 3 sind die rückwärtigen Steckanschlüsse 31 gezeigt. Es können zum Beispiel Anschlüsse für die Stromversorgung, für die Interfaces in Form von beispielsweise PS/2- oder USB-Schnittstellen und/oder für die grafische Ausgabe vorgesehen sein. Ebenso sind noch weitere Anschlüsse denkbar. Es besteht auch die Möglichkeit, bei der Verwendung eines USB-Anschlusses, auf die PS/2-Anschlüsse zu verzichten und die Kommunikation mit den Eingabe-Interfaces nur über den USB-Anschluss auszuführen. Hierbei würde beispielsweise ein USB-Hub auf der Leiterplatte vorgesehen werden, um die Verwendung von mehreren Interfaces zu ermöglichen. Vorteilhaft an der Verbindung der Eingabe Interfaces mit USB ist auch, dass nur noch eine Zuleitung für alle Interfaces benötigt wird. Somit wird der Verkabelungsaufwand beim Einbau eines derartigen Display-Auszuges verringert, im Vergleich zu einem klassischen Anschluss mit jeweils einem PS/2-Anschluss für Tastatur und einer weiteren taktilen Eingabeeinrichtung, wie einer Maus oder einem Touchpad.

Die Kabelführung 11 dient dazu, die Zuleitungskabel, die zu dem entsprechenden Servern führen, geordnet aufzunehmen, damit es keine Probleme beim Herausziehen beziehungsweise Einschieben des Display-Auszuges 1 gibt. Ebenso ist es denkbar, im hinteren Bereich des Auszuges 1 zusätzlich ein oder mehrere KVM-Switch einzubauen, um mehrere Server anzusteuern zu können.

Das erfindungsgemäße Konzept für einen Display-Auszug bietet somit ein einfaches und effektives System, das den Austausch erleichtert und besonders integriert aufgebaut ist.

## Patentansprüche

1. Display-Auszug (1) für Elektronikschränke oder Elektronikgeräte,
mit mindestens einem, im Wesentlichen flachen Display (2) und
mit mindestens einem Eingabe-Interface (3, 5),
wobei das mindestens eine Display (2) und das mindestens eine Eingabe-Interface (3, 5) von einer Platz sparenden Aufbewahrungsposition in einem Elektronikschrank oder Elektronikgerät, in eine Arbeitsposition zur Bedienung des mindestens einen Inferfaces (3, 5) überführbar sind, und
ein Eingabe-Interface (3, 5) als Tastatur (3) ausgeführt ist,
**dadurch gekennzeichnet,**
**dass** an der rückwärtigen Seite des Display-Auszuges (1) Steck-Anschlüsse (31), insbesondere für eine trennbare Display-, Interface- und/oder Energieversorgung, vorgesehen sind und
**dass** mindestens die Tastatur (3) durch einzelne Tastaturmodule (4), die auf einer Leiterplatte integriert sind, ausgebildet ist.

2. Display-Auszug nach Anspruch 1,
**dadurch gekennzeichnet,**
**dass** auf der Leiterplatte eine integrierte Aufnahme für ein Touchpad (5) vorgesehen ist.

3. Display-Auszug nach Anspruch 1 oder 2,
**dadurch gekennzeichnet,**
**dass** auf der Leiterplatte Interface-Controller vorgesehen sind, insbesondere für PS/2 und/oder USB.

4. Display-Auszug nach einem der Ansprüche 1 bis 3,
**dadurch gekennzeichnet,**
**dass** an der vorderen Seite des Auszugs (1) eine austauschbare Blende (9) vorgesehen ist.

5. Display-Auszug nach einem der Ansprüche 1 bis 4,
**dadurch gekennzeichnet,**
**dass** zur Überführung von der Aufbewahrungsposition in die Arbeitsposition vertikale Trage- und Gleitschienen (8, 21) vorgesehen sind, welche konstruktiv mit dem Elektronikschrank oder dem Elektronikgerät verbunden sind.

6. Display-Auszug nach einem der Ansprüche 1 bis 5,
**dadurch gekennzeichnet,**
**dass** die Außenabmessungen für 19"-Schränke ausgelegt sind und dass die Höhe 1 HE beträgt.

7. Display-Auszug nach einem der Ansprüche 1 bis 6,
**dadurch gekennzeichnet,**
**dass** in der Aufbewahrungsposition das Display (2) flach auf dem mindestens einen Eingabe-Interface (3, 5) abklappbar ist.

8. Display-Auszug nach einem der Ansprüche 1 bis 7,
**dadurch gekennzeichnet,**
**dass** die Leiterplatte als Mehrschicht-Leiterplatte ausgebildet ist.

9. Display-Auszug nach einem der Ansprüche 1 bis 8,
**dadurch gekennzeichnet,**
**dass** die Tastatur (3) mit gelaserter Beschriftung ausgestattet ist.

10. Display-Auszug nach einem der Ansprüche 2 bis 9,
**dadurch gekennzeichnet,**
**dass** beabstandet zum Touchpad (5) beidseitig abgerundete Handballenauflagen (6) vorgesehen sind.
